# EUROPEAN PATENT APPLICATION

(11) **EP 2 782 124 A1**
(43) Date of publication of application: **24.09.2014**
(21) Application number: 13159954.0
(22) Date of filing: 19.03.2013
(51) Int. Cl.: H01L 21/60, H01L 23/488

(54) **Power semiconductor mounting**

(71) Applicant: ABB Technology AG, 8050 Zürich (CH)
(72) Inventor: Dugal, Franc, 8702 Zollikon (CH)
(74) Representative: ABB Patent Attorneys

(57) **Abstract**

The present invention provides a method for forming a joint (13) between a high power semiconductor (11) and a metallization of a substrate (12), comprising the steps of providing an electrically conducting preform (14), bonding the preform (14) onto the substrate (12), thereby forming a first bonding layer (15) between the substrate (12) and the preform (14), and bonding the high power semiconductor (11) onto the preform (14), thereby forming a second bonding layer (16) between the preform (14) and the high power semiconductor (11). The present invention further provides a method for mounting a high power semiconductor (11) onto a metallization of a substrate (12), comprising the step of forming a joint (13) according to the above method between the high power semiconductor (11) and the substrate (12). Still further, the invention provides a joint (13) between a high power semiconductor (11) and a metallization of a substrate (12), whereby the joint (13) is formed according to the above method as well as an assembly (10) comprising a high power semiconductor (11) and a substrate (12), whereby the substrate (12) comprises a metallization and the high power semiconductor (11) is mounted to the metallization with a joint (13) formed according to the above method.

## Description

### Technical Field

The present invention relates to the field of mounting power semiconductors on metallizations of substrates. In particular, the present invention relates to forming joints between power semiconductors and metallizations of substrates.

### Background Art

Soldering is the main assembly method for electronic devices. Soldering joints usually have a thickness of less than 500 µm, typically about 200 µm. In the area of high power semiconductor devices, commonly used alloys used for soldering do not provide sufficient reliability for the joints. In particular, at high working temperatures, soldering connections do not provide required reliability of the connection. This problem has been further increased, since lead free alloys have been introduced to replace standard lead alloys for the assembly of microelectronic components. Soldering using since lead free alloys is generally more complicated.

Therefore, new joining methods have been developed, generally referred to as bonding, including silver sintering or transient liquid phase bonding. Bonding has the advantages that the resulting joint has a good reliability and enables the use at high working temperatures. Nevertheless, when using those bonding methods, e.g. for mounting a high power semiconductor onto a metallization of a substrate, the resulting joint is thin compared to a soldering joint, so that it requires special roughness and flatness specifications. Furthermore, relaxation of mechanical stress produced during the mounting is not feasible.

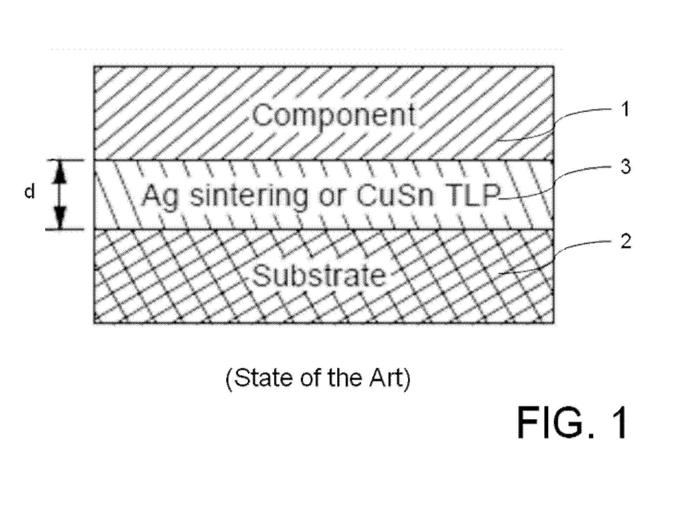

Such a state of the art bonding process is described with reference to Fig. 1. An electric component 1 is mounted onto a metallization of a substrate 2 by means of a bonding layer 3, which corresponds to the joint. The bonding layer 3 in this state of the art example is a silver sintering layer. Volume losses during silver sintering limit the thickness of the joint, i.e. the bonding layer 3, to typical values between 20 µm and 50 µm. If the bonding layer 3 is too thick, cracks will appear during the sintering process. Those cracks reduce thermal and electrical conductivity as well as mechanical properties of the joint.

In an alternative bonding process known in the art, a bonding layer 3 is formed as joint between an electric component 1 and a metallization of a substrate 2 by transient liquid phase bonding. The diffusion speed of the melted metal limits a thickness d of the bonding layer 3 to typical values of approximately 20 µm for reasonable process times. In a thin-copper system, the goal is to transform the complete joint 3 into a Cᵤ₆Sₙ₅ intermetallic phase. Increasing the thickness of the deposited tin layer produces an increased spill of liquid tin, and the joint 3 will comprise different layers, one composed of the Cᵤ₆Sₙ₅ intermetallic phase as well as a layer of pure tin. The remaining tin layer in the bonding layer 3 will considerably reduce the working temperature and mechanical properties of the joint 3.

### Disclosure of Invention

It is an object of the present invention to provide a method for providing a joint with good electrical, thermal and mechanical properties, which can easily be formed. In particular, it is an object to provide a joint with high resistance to mechanical stress, which can be provided with good reliability as well as high thermal and electrical conductivity, and is suitable for high working temperatures. Furthermore, it is an object to provide a method for reliably mounting a high power semiconductor onto a substrate.

This object is achieved by the independent claim. Advantageous embodiments are given in the dependent claims.

In particular, the present invention provides a method for forming a joint between a high power semiconductor and a metallization of a substrate, comprising the steps of providing an electrically conducting preform, bonding the preform onto the substrate, thereby forming a first bonding layer between the substrate and the preform, and bonding the high power semiconductor onto the preform, thereby forming a second bonding layer between the preform and the high power semiconductor.

The present invention further provides a method for mounting a high power semiconductor onto a metallization of a substrate, comprising the step of forming a joint according to the above method between the high power semiconductor and the substrate.

The present invention also provides a joint between a high power semiconductor and a metallization of a substrate, whereby the joint is formed according to the above method.

The present invention further provides an assembly comprising a high power semiconductor and a substrate, whereby the substrate comprises a metallization and the high power semiconductor is mounted to the metallization with a joint formed according to the above method.

The basic idea of the invention is to increase the thickness of the joint between the substrate and the component, i.e. the high power semiconductor, by providing the preform between the two bonding layers. With the increased thickness, the resulting joint enables the relaxation of mechanical stress produced during the mounting. Each of the two bonding layers can be provided with a thickness normal for the applied bonding process, so that each of the two bonding layers as well as the resulting joint have a good reliability and enable the use at high working temperatures.

The joint is in particular formed between the metallization of the substrate and a contact pad of the component, i.e. a contact pad of a high power semiconductor. The order of the bonding steps can be exchanged, either the preform is first bonded to the component and then to the substrate, or the preform is first bonded to the substrate and then to the component.

With the above method, the joint is provided with a number of four bonding interfaces, one on the metallization of the substrate, one on the surface of the component, and one on each face of the preform. The preform can be of any suitable material. Preferably, the preform is provided with a material that does not melt during the bonding steps, but reacts with the bonding material in order to form a solid joint. Bonding steps can be performed depending on the materials of the substrate, the preform and the component to provide a reliable connection between the respective bonding partners. Commonly used materials of metallizations and contact pads are copper or other metallic materials suitable for bonding. The metallizations and contact pads may also be provided with a coating, e.g. a silver or gold coating.

According to a modified embodiment of the invention the step of providing an electrically conducting preform comprises providing a preform having a thickness of less than 1 mm, preferably 50 µm to 250 µm, further preferred 100 µm to 200 µm. This thickness of the preform is suitable to provide a reliable joint between the substrate and the component, which has a sufficient thickness to enable the relaxation of mechanical stress produced during the mounting.

According to a modified embodiment of the invention the step of providing an electrically conducting preform comprises providing a preform made of silver, bronze or copper. These materials have a good electrical and thermal conductivity and are therefore suitable for being used in the joint. Furthermore, these materials are suitable for use in different bonding processes.

According to a modified embodiment of the invention the step of providing an electrically conducting preform comprises providing a preform having a tin coating. The tin has a low melting temperature and can be used as a component for forming the bonding layer. This facilitates the respective bonding process step.

According to a modified embodiment of the invention the step of bonding the preform onto the substrate and/or bonding the high power semiconductor onto the preform comprises providing the respective bonding layer with a thickness of less than 50 µm, preferably 5 µm to 40 µm, further preferred 10 µm to 30 µm. A bonding layer having such a thickness can be provided with known bonding processes with good reliability, so that the respective bonding layer has good electrical and thermal conduction properties.

According to a modified embodiment of the invention the step of bonding the preform onto the substrate and/or bonding the high power semiconductor onto the preform comprises transient liquid phase bonding. Transient liquid phase bonding is a joining process that is applicable for bonding many metallic and ceramic materials and produces joints with a uniform composition profile, tolerant of surface oxides and geometrical defects.

According to a modified embodiment of the invention the step of bonding the preform onto the substrate and/or bonding the high power semiconductor onto the preform comprises silver sintering. Silver sintering is especially suitable for high temperature applications and requires a low process temperature, so that it can be easily formed.

### Brief Description of Drawings

These and other aspects of the invention will be apparent from and elucidated with reference to the embodiments described hereinafter.

In the drawings:

Fig. 1 shows an assembly comprising a substrate and an electric component with a joint according to the state of the art,

Fig. 2 shows an assembly comprising a substrate and an electric component with a joint according to a first embodiment, and

Fig. 3 shows an assembly comprising a substrate and an electric component with a joint according to a second embodiment.

### Detailed Description of the Invention

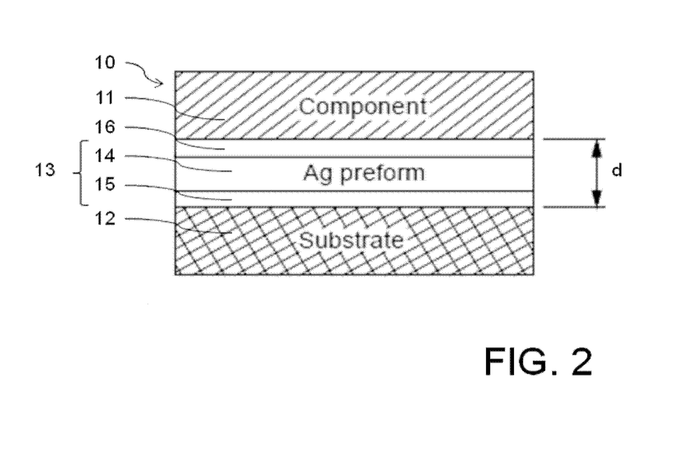

Fig. 2 shows an assembly 10 comprising an electric component 11 and a substrate 12. The electric component 11 in this embodiment is a high power semiconductor.

The high power semiconductor 11 is mounted on the substrate 12 with a joint 13, which provides thermal and electrical conductivity between the high power semiconductor 11 and the substrate 12. In particular, it is to be noted, that the high power semiconductor 11 is mounted with a contact pad, which is not explicitly shown in the figure, on a metallization, which is not explicitly shown in the figure, of the substrate 12.

For forming the joint 13, first a preform 14 made of silver is provided. The preform 14 has a thickness of 150 µm. The preform 14 is bonded onto the substrate 12, thereby forming a first bonding layer 15 between the substrate 12 and the preform 14. Next, the high power semiconductor 11 is bonded onto the preform 14, thereby forming a second bonding layer 16 between the preform 14 and the high power semiconductor 11. In an alternative embodiment, the step of bonding the high power semiconductor 11 onto the preform 14 is performed prior to the step of bonding the preform 14 onto the substrate 12. The above bonding steps comprise silver sintering, which is known in the Art. The silver sintering provides the bonding layers 15, 16 with a thickness of approximately 20 µm. This results in the entire joint 13 having a thickness of approximately 190 µm.

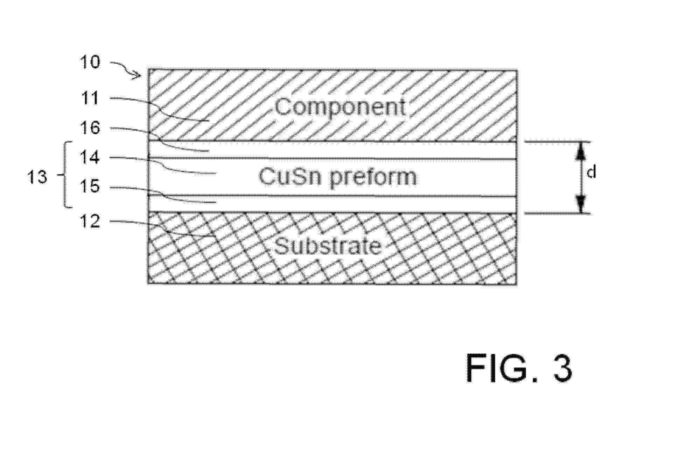

A second embodiment, which is shown in Fig. 3, is similar to the first embodiment as described above. Accordingly, the same reference numerals are used for similar components.

Fig. 3 shows an assembly 10 comprising an electric component 11 and a substrate 12. The electric component 11 in this embodiment is a high power semiconductor.

The high power semiconductor 11 is mounted on the substrate 12 with a joint 13, which provides thermal and electrical conductivity between the high power semiconductor 11 and the substrate 12. In particular, it is to be noted, that the high power semiconductor 11 is mounted with a contact pad, which is not explicitly shown in the figure, on a metallization, which is not explicitly shown in the figure, of the substrate 12.

For forming the joint 13, first a preform 14 made of bronze is provided. The preform 14 has a thickness of 140 µm. Then the preform 14 is bonded onto the substrate 12, thereby forming a first bonding layer 15 between the substrate 12 and the preform 14. Next, the high power semiconductor 11 is bonded onto the preform 14, thereby forming a second bonding layer 16 between the preform 14 and the high power semiconductor 11. In an alternative embodiment, the step of bonding the high power semiconductor 11 onto the preform 14 is performed prior to the step of bonding the preform 14 onto the substrate 12. The above bonding steps comprise transient liquid phase bonding, which is known in the Art. The transient liquid phase bonding provides the bonding layers 15, 16 with a thickness of approximately 15 µm. This results in the entire joint 13 having a thickness of approximately 170 µm.

While the invention has been illustrated and described in detail in the drawings and foregoing description, such illustration and description are to be considered illustrative or exemplary and not restrictive; the invention is not limited to the disclosed embodiments. Other variations to be disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

**Reference signs list**

| | |
|---|---|
| 1 | electric component |
| 2 | substrate |
| 3 | bonding layer, joint |
| d | thickness |
| 10 | assembly |
| 11 | electric component, high power semiconductor |
| 12 | substrate |
| 13 | joint |
| 14 | preform |
| 15 | first bonding layer |
| 16 | second bonding layer |

## Claims

1. Method for forming a joint (13) between a high power semiconductor (11) and a metallization of a substrate (12), comprising the steps of
providing an electrically conducting preform (14),
bonding the preform (14) onto the substrate (12), thereby forming a first bonding layer (15) between the substrate (12) and the preform (14), and
bonding the high power semiconductor (11) onto the preform (14), thereby forming a second bonding layer (16) between the preform (14) and the high power semiconductor (11).

2. Method according to claim 1,
whereby
the step of providing an electrically conducting preform (14) comprises providing a preform (14) having a thickness of less than 1 mm, preferably 50 µm to 250 µm, further preferred 100 µm to 200 µm.

3. Method according to any of preceding claims 1 or 2,
whereby
the step of providing an electrically conducting preform (14) comprises providing a preform (14) made of silver, bronze or copper.

4. Method according to any of preceding claims 1 to 3,
whereby
the step of providing an electrically conducting preform (14) comprises providing a preform (14) having a tin coating.

5. Method according to any of preceding claims 1 to 4,
whereby
the step of bonding the preform (14) onto the substrate (12) and/or bonding the high power semiconductor (11) onto the preform (14) comprises providing the respective bonding layer (15, 16) with a thickness of less than 50 µm, preferably 5 µm to 40 µm, further preferred 10 µm to 30 µm.

6. Method according to any of preceding claims 1 to 5,
whereby
the step of bonding the preform (14) onto the substrate (12) and/or bonding the high power semiconductor (11) onto the preform (14) comprises transient liquid phase bonding.

7. Method according to any of preceding claims 1 to 6,
whereby
the step of bonding the preform (14) onto the substrate (12) and/or bonding the high power semiconductor (11) onto the preform (14) comprises silver sintering.

8. Method for mounting a high power semiconductor (11) onto a metallization of a substrate (12), comprising the step of
forming a joint (13) according to any of method claims 1 to 7 between the high power semiconductor (11) and the substrate (12).

9. Joint (13) between a high power semiconductor (11) and a metallization of a substrate (12), whereby the joint (13) is formed according to any of method claims 1 to 7.

10. Assembly (10) comprising a high power semiconductor (11) and a substrate (12), whereby the substrate (12) comprises a metallization and the high power semiconductor (11) is mounted to the metallization with a joint (13) formed according to any of method claims 1 to 7.
